(19) Europäisches Patentamt
European Patent Office
Office européen des brevets

(11) **EP 1 895 595 B1**

(12) **EUROPEAN PATENT SPECIFICATION**

(45) Date of publication and mention
of the grant of the patent:
**08.05.2013 Bulletin 2013/19**

(51) Int Cl.:
***H01L 29/66*** *(2006.01)*  ***H01L 29/739*** *(2006.01)*
***H01L 29/06*** *(2006.01)*

(21) Application number: **07021535.5**

(22) Date of filing: **17.10.1997**

(54) **Semiconductor device and electric power conversion apparatus therewith**

Halbleitervorrichtung und elektrische Stromwandlervorrichtung

Dispositif semiconducteur et appareil de conversion d'énergie électrique correspondant

(84) Designated Contracting States:
**DE FR GB**

(30) Priority: **18.10.1996 JP 27584496**

(43) Date of publication of application:
**05.03.2008 Bulletin 2008/10**

(62) Document number(s) of the earlier application(s) in
accordance with Art. 76 EPC:
**97308267.0 / 0 837 508**

(73) Proprietor: **Hitachi, Ltd.**
**Chiyoda-ku**
**Tokyo 100-8280 (JP)**

(72) Inventors:
• **Mori, Mutsuhiro**
**Mito-shi**
**Ibaraki 310 (JP)**

• **Uchino, Yoshihiro**
**Tokyo 100-8220 (JP)**

(74) Representative: **Johnson, Richard Alan et al**
**Mewburn Ellis LLP**
**33 Gutter Lane**
**London**
**EC2V 8AS (GB)**

(56) References cited:
**EP-A- 0 735 591    EP-A1- 0 615 292**
**GB-A- 2 113 907    GB-A- 2 243 952**
**JP-A- 3 205 832    US-A- 5 382 538**

• **PATENT ABSTRACTS OF JAPAN vol. 012, no. 420 (E-679), 8 November 1988 (1988-11-08) & JP 63 157477 A (NISSAN MOTOR CO LTD), 30 June 1988 (1988-06-30)**

EP 1 895 595 B1

# Description

The present invention relates to a semiconductor device which has such overall features that the device and apparatus can be easily manufactured, the feedback capacitance causing noises is small, high withstand voltage can be easily established, the turn-on voltage is small and the switching operation is fast, and to an electric power conversion apparatus using this semiconductor device.

In the semiconductor devices for controlling high voltage, it is strongly required to establish lower losses in various operations. For the in-operation status, it is required that the voltage drop in the semiconductor device, that is, ON voltage is small, and switching operation can be performed in high speed, and switching loss is small. In addition, in responsive to recent various noise regulations, low-noise type semiconductor devices in which overshooting peak voltage can be reduced in fast switching operations are required. As well as low overshooting peak voltage, reliability for blocking high voltage is expected. And more, in order to meet the challenge for cost-oriented marketing, it is strongly required that the semiconductor devices can be easily fabricated for manufactures, easily used for users, and easily controlled. Under those technical and business environment, newly designed semiconductor devices are proposed by integrating MOS gates, transistors and thyristors. In the followings, four examples in conventional semiconductor devices are described.

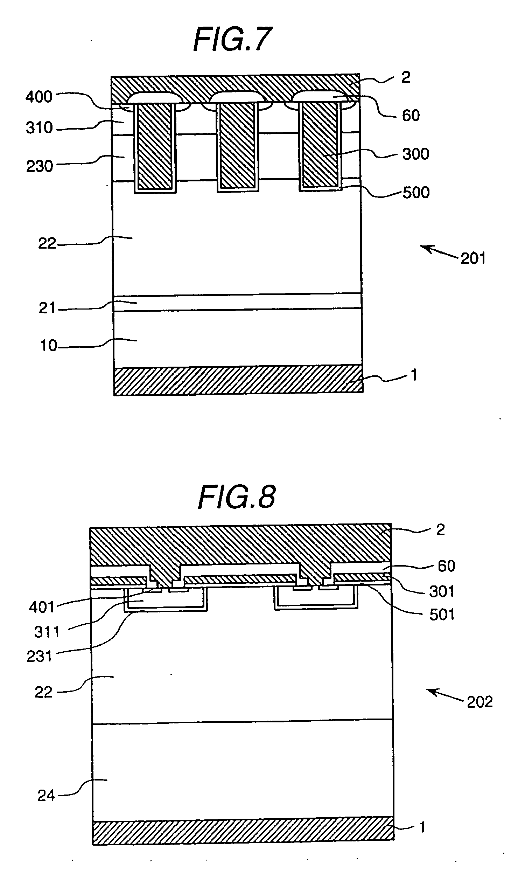

FIG. 7 is a cross section of the Insulation Gate Type Bipolar Transistor (IGBT) having a groove-shaped trench gate. The device 201 has a normal structure of Trench-Gate Type IGBT and also includes an n layer 230 storing the carrier between the gates. This device is called "Carrier Stored Trench-Gate Bipolar Transistor (CSTBT), and is presented at the International Symposium of Power Semiconductor Devices and ICs (ISPSD, 1996, pp. 349-352).

In the device 201 shown in FIG. 7, the n butter layer 21 is formed on the p+ substrate 10, and the n-layer 22 is developed on the n butter layer 21. On the top of the device, a groove is formed in the silicon layer, in which the gate oxidization layer 500 and the gate electrode 300 are formed and the gate electrode 300 is covered by the insulation layer 60. The p layer 310 is formed between the adjacent gate substrates 300, the n layer 230 is formed below the p layer 310, and the n+ layer 400 is formed in the p layer 310, and the p layer 310 and the n+ layer 400 contact to the emitter electrode 2 with low resistance. The p+ layer 10 contacts to the collector electrodes 1 with low resistance.

The difference of the device 202 from the IGBT having a normal trench gate is the addition of the n layer 230. With this structure, the plus charge (hole) is injected from the p+ layer 10 can be stored in the n layer 230, and the minus charge (electron) of the n+ layer 400 is injected from the n layer 230 through the inversion layer formed on the surface of the p layer 310 facing to the gate electrode 300 to the carrier-less n- layer 22, and thus, the conduction modulation in the n- layer 22 can be promoted. The conduction modulation in the n- layer 22 at the neighboring area of the p layer 310 which has ever been difficult in the conventional IGBT can be increased, and therefore, the ON voltage can be decreased. In addition, by forming the n layer 230 with the depth equivalent to the depth of the trench gate electrode 300, the ON voltage can be reduced as well as the withstand voltage can be maintained to be high enough.

FIG. 8 shows a Power MOS FET 202 having an n+ substrate 24 different from IGBT. The device 202 is disclosed in Japanese Patent Application Laid-Open No. 61-150378 (1986), in which a planar-type MOS gate is formed on the surface of the n- layer 22 on the n+ substrate 24. The MOS gate is composed of the gate insulation film 501 and the gate substrate 301, and the gate substrate 301 is covered by the insulation film 60. Not like a trench gate, the gate electrode 301 is formed on an almost flat surface. The p layer 311 and the n+ layer 401 are diffused from the midpoint of the gate electrode 301 toward the inside of the n- layer 22, and thus, an n-channel MOS FET structure is formed on the surfaces of the n+ layer 401, the p layer 311 and the n-layer 22 below the gate electrode 301. The drain electrode 1 contacts to the n+ substrate with low resistance, and the source electrode 2 contacts to the n+ layer 401 and the p layer 311 with low resistance. The specific feature of the device 202 shown in FIG. 8 is that the p layer 311 is surrounded by the n layer 231. With this structure, the specific feature of the device 202 is that the growth of the depletion layer generated in the n- layer due to the reverse bias between the p layer 311 and the n- layer 22 in on-operation of the device can be reduced, and that the electric current runs smoothly without resistance obstacle and thus the ON resistance can be reduced by regulating the pinch effect between the p layers 311. In Japanese Patent Application Laid-Open No. 61-150378 (1986), the conditions of the n layer 231 for reducing the growth of the depletion layer in on-operation of the device is described.

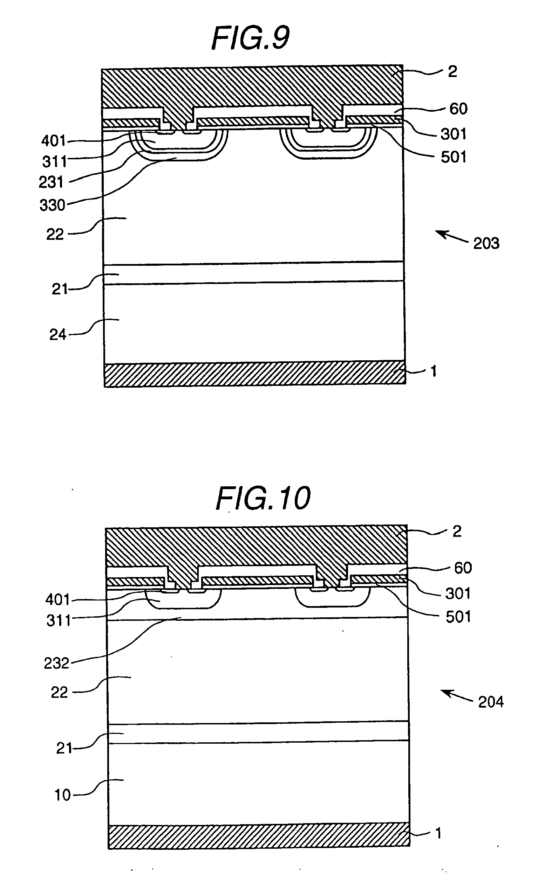

FIG. 9 shows the thyristor 203 for MOS control disclosed in Japanese Patent Application No. 5-82775 (1993) in which the p+ substrate 10 is used and the p layer is so formed as to surround the n layer 231, not like the device shown in FIG. 8. The device shown in FIG. 9 has such a specific feature that, by forming the p layer 330, the thyristor composed of the n layer 231, the p layer 330, the region between the n- layers, the n buffer layer 21 and the p substrate 10 can be electrically operated, and thus the ON voltage can be reduced greatly.

The device shown in FIG. 10 has such a specific feature that the p+ substrate 10 is used and the n layer 232 having the uniform depth larger than the depth of the p layer 311, not like the device shown in FIG. 8. Owing to this structure, by means that the region defined between the p layers 311 is formed as the high density n layer 232, the junction FET effect due to the p layer 311 can be reduced, and hence the ON voltage can be reduced. As described above, various semiconductor devices have been proposed. As for a semiconductor device which can be easily manufactured and in which the feedback capacitance causing noises is small, high withstand voltage can be easily established, the turn-on voltage is small and the switching operation is fast, those conventional semiconductor devices have more than one problems, and hence, it can not be concluded yet that those devices are good in overall performances. Therefore, in case of applying those devices to electric power conversion apparatus, it is afraid that various problems generic to power conversion operation s may arise.

For example, in the semiconductor device shown in FIG. 7, due to the formation of the n layer 230, the electric field is so much concentrated at the corner of the bottom of the trench gate, and the reliability of the gate insulation film may be reduced. Though the ON voltage can be made lower by making larger the depth of the n layer 230, the area of the contact interface between the gate electrode 300 and the n layer 230 and the area of the contact interface between the gate electrode 300 and the n- layer 22 increase due to the increase of the depth of the n layer 230, and the feedback capacitance of the gate may increase. In case that the feedback capacitance increases, the voltage pulsation when switching causes the large amount of electric current run through the gate electrode into the gate circuit, which leads to the noise generation and the error in the circuit operation followed by the abnormal operation of the electric power conversion apparatus, and in the ultimate worst case, the devices and apparatus may be damaged. In addition, it is required to regulate the depth of the trench gate and the depth of the n layer 230 in the fabrication process. Especially for the trench gate fabricated by the dry etching process, it is difficult to form the uniform depth of the trench gate in a single silicon wafer; if the depth of the n layer 230 is larger than the depth of the trench gate, the withstand voltage may be reduced, and if the depth of the n layer 230 is made to be smaller for preventing the reduction of the withstand voltage, the effect for storing the carrier can not be established, which leads to the increase in the ON voltage.

On the other hand, as the n+ substrate 24 is used in the semiconductor apparatus show in FIG. 8, which is formed as a plural-carrier device, and the injection of the hole described in FIG. 7 does not occur, the deviation in the conductivity is not expected but the high ON voltage can be obtained.

The semiconductor device shown in FIG. 9 has a 6-layered pnpnpn structure, and has difficulty in fabricating the device for controlling the depth of the individual diffusion layers 330, 231, 331 and 401, and in addition, as the number of the diffusion layers is large, the threshold voltage of the MOS gate defined by the density of the individual layers is unstable. As the hole stored in the p layer 330 is discharged through the p channel with high resistance on the surface of the n layer 231 to the cathode electrode 2 when turning off the device, there is such a problem that the switching speed is slow.

As the n layer 232 is also located below the MOS gate in the semiconductor device shown in FIG. 10, the depletion layer below the MOS gate is difficult to be extended, and the withstand voltage tends to decrease. In addition, the feedback capacitance is large because the depletion layer is difficult to be extended, the erroneous operation of the device may be caused due to the noises generated at the gate as described with FIG. 7.

JP-A-63-157477A discloses a conductivity modulatioh type MOSFET to boost the latch up withstand voltage by a method wherein an n-base and an n well with concentration thereof gradually lowered from the surface are laminated on a p+ layer p base layers and n source layers are provided on the n well and gate electrodes are provided on the p bases between the p base layers and n source layers through the intermediary of insulating films.

EP-A-0735591 discloses a DMOS device structure wherein the lightly doped body regions are contained in respective enhancement regions of the lightly doped semiconductor layer of the same conductivity type as but with a lower resistivity than the lightly doped semiconductor layer.

JP-A-03-205832 discloses a vertical power MOSFET in which a heavily doped layer of the same conductivity type as a substrate is buried between the substrate and a well layer to make the device more resistant to breakdown current.

GB 2113907 discloses a semiconductor PN device having an additional high impurity region buried adjacent to the PN junction to ensure current flows in the bulk of the device when reverse breakdown occurs.

An object of the present invention is to provide a semiconductor device which has such overall and well-coordinated good features that the device and apparatus can be easily manufactured, the feedback capacitance causing noises is small, high withstand voltage can be easily established, the turn-on voltage is small and the switching operation is fast, and provide an electric power conversion apparatus using this semiconductor device.

According to the present invention there is provided a semiconductor device as set out in claim 1.

According to the present invention, as the third semiconductor region works as a barrier having less carriers in the second semiconductor regions, the amount of stored carriers in the second semiconductor region increases, and ON voltage can be reduced.

In the drawings

FIG. 1 is a cross section of a device not forming part of the claimed invention.

FIG. 2 is an example of the carrier density distribution along the line A-A' in FIG. 1.

FIG. 3 is a graph showing the sheet carrier density and the characteristic.

FIG. 4 is a graph showing the thickness of the n layer and the characteristic.

FIG. 5 is an example of the electric conversion apparatus applied with the semiconductor device of the present invention.

FIG. 6 is an embodiment of the lateral semiconductor device of the present invention.

FIG. 7 is a cross section of the prior art.

FIG. 8 is a cross section of another prior art.

FIG. 9 is a cross section of another prior art.

FIG. 10 is a cross section of another prior art.

FIG. 11 a device not forming part of the claimed invention.

FIG. 12 is an IGBT in the prior art.

FIG. 13 a device not forming part of the claimed invention.

FIG. 14 a device not forming part of the claimed invention.

FIG. 15 a device not forming part of the claimed invention.

FIG. 16 a device not forming part of the claimed invention.

FIG. 17 is an example of the striped cell in the IGBT applying the present invention.

FIG. 18 is an example of the IGBT chip cell applying the present invention.

FIG. 19 is a termination of a device not forming part of the claimed invention.

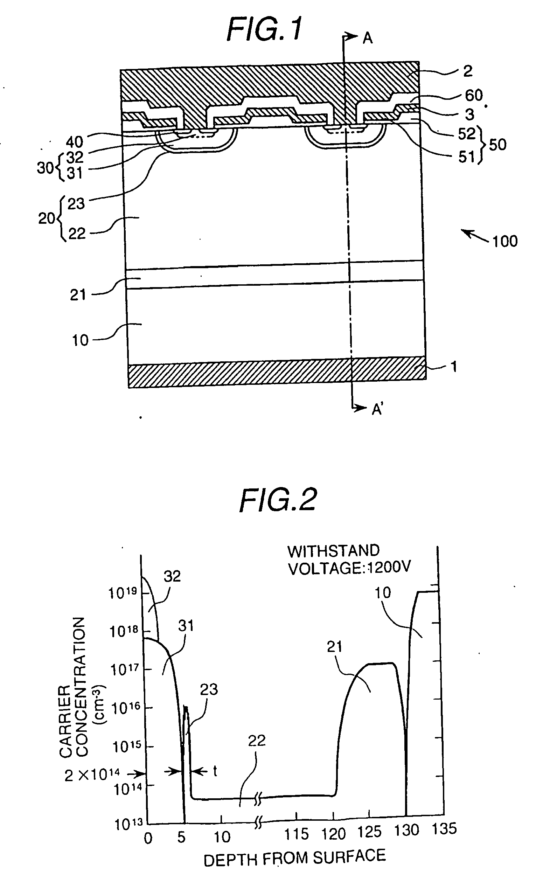

Now, a device not forming part of the claimed invention is described in detail by referring to FIG. 1. The semiconductor device 100 of this embodiment has a pair of main surfaces, the individual surface almost parallel to each other, in which the n butter layer 21 is formed on the p+ layer 10 exposed to one of the main surfaces, and the n- layer 22 is formed on the n buffer layer 21 exposed to the other of the main surfaces. The n layer 23 having the carrier density higher than that of the n- layer 22 is diffused from the other main surface into the n- layer 22. The p layer 31 is so diffused as to be surrounded by the n layer 23. The n+ layer 40 is introduced in the p layer 31. On the surfaces of the p layer 31 and the n layer 23, the gate insulation film 51 is formed on one of the main surfaces so as to bridge the n+ layer 40 and the n- layer 22, and the gate electrode 3 is formed on the gate insulation film 51. On the other main surface, the emitter electrode 2 is formed inn the n+ layer 40 and the p layer 31 and contact with low resistance to the p+ layer 32 extending to the underneath of the n+ layer 40.

FIG. 2 shows the carrier density distribution in the cross section at A-A' by referring to the embodiment shown in FIG. 1, in case that the withstanding voltage is 1200V. The n buffer layer 21 having the carrier density about $1 \times 10^{17}$ cm$^{-3}$ with its thickness about 10 $\mu$m, is formed on the p+ layer having the carrier density $1 \times 10^{18}$ cm$^{-3}$ or higher, and the n- layer 22 having the carrier density $5.0 \times 10^{13}$ cm$^{-3}$ or less with its thickness about 120 $\mu$m, is formed on the n butter layer 21, both developed by epitaxial growth method. The carrier density of the n layer 23 diffused from the other main surface is in the order between about $10^{15}$ cm$^{-3}$ and $10^{16}$ cm$^{-3}$, and its thickness is a few microns. The carrier density of the p layer 31 is in the order of 10 17 cm -3, and its thickness

is about 5 $\mu$m. On the surface of the p layer 31, the p+ layer 32 having the carrier density $10^{16}$ cm$^{-3}$, or over for making the p layer 31 low resistance.

In order to making the semiconductor device 100 turned ON, the positive electric potential is applied from the emitter electrode to the gate electrode 3 while the negative electric potential applied to the emitter electrode 2 and the positive electric potential applied to the collector electrode 1. The n-type inversion layer is formed on the surface of the p layer 31 below the gate electrode 3, and the electrons are injected into the p+ layer 10 through the n+ layer 40, the inversion layer, the n layer 23, the n- layer 22 and the n butter layer. In responsive to the injected electrons, the holes are injected from the n+ layer to the n butter layer 21 and the n- layer 22. Then, the electric conductivity of the n- layer 22 changes and its resistance decreases, and thus, the semiconductor device gets to lower ON voltage. The semiconductor device 100 also has the same feature as the prior art shown in FIG. 7, in which there is such an effect that the holes injected from the n layer 23 are prevented from being diffused in the p layer 31 but remain in the n- layer 22, and the ON voltage decreases more than the normal IGBT without the n layer 23.

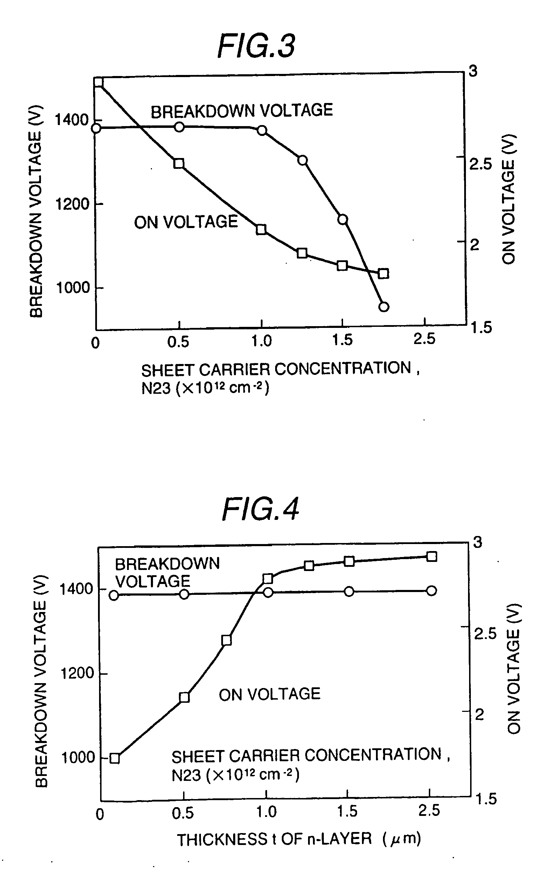

The feature of the semiconductor device 100 different from that shown in FIG. 7 is proved that, as the there is no junction FET effect by the trench gate, it is not required to form the n layer 23 deeply but it is effective to make the n layer 23 thinner and its carrier density higher. FIG. 3 shows the result of this study, which shows the relation between the sheet carrier density N 23 and the ON voltage as well as the breakdown voltage in the n layer 23 shown in FIG. 2. It is found from FIG. 3 that, the higher the sheet carrier density, the more the ON voltage can be decreased. It is also found that the breakdown voltage decreases too much when the sheet carrier density is $1 \times 10^{12}$ cm$^{-2}$ or higher. From those results, it is preferable that the sheet carrier density of the n layer 23 is defined so as to be $1 \times 10^{12}$ cm$^{-2}$ or less. FIG. 4 shows the relation between the sheet carrier density and the ON voltage as well as the breakdown voltage in the n layer 23, when the sheet carrier density is $1 \times 10^{12}$ cm$^{-2}$. The thickness of the n layer 23 is regulated as the thickness t defined with the carrier density $2 \times 10^{14}$ cm$^{-3}$. As found from FIG. 4, it is preferable that the thinner the n layer 23, the more the ON voltage can be reduced effectively without the breakdown voltage, and, consequently, the thickness of the n layer 23 is preferably defined to be 4 $\mu$m or less. This is because, the thinner the layer having an identical sheet carrier density, the higher the carrier density of the layer per unit volume, and the storing effect by the holes. In more detail study, the fact that the peak of the carrier density per unit volume of the n layer 23 is $2.5 \times 10^{15}$ cm$^{-3}$ or higher is effective for the reduction of the ON voltage. This means that the storing effect of the holes is small if the carrier density is $2.5 \times 10^{15}$ cm$^{-3}$ or less.

As described above, as the n layer 23 can be formed so that its thickness may be small enough, the cross section of the n layer 23 facing to the gate electrode 3 can be made small. Therefore, the increase of the feedback capacitance due to the high density of the n- layer 22 can be made as small as possible. In the semiconductor device 1000, the extension of the depletion layer is restricted by forming the n layer 230 as in the trench gate shown in FIG. 7, and there is no fear that the reliability of the gate insulation film 500 is lost due to the high electric field more applied to the corner of the gate insulation film 500. In addition, there is no difficulty in controlling the depth of the trench gate and the n layer 230, and in this embodiment, by ion implantation, the density of the n layer 23 and the p layer 31 can be controlled precisely, and its depth can be controlled by adjusting the diffusion temperature and time, and therefore, there is no difficulty in fabrication processes like trench gate.

Though the conduction modulation does not occur in the semiconductor apparatus 202 shown in FIG. 8 because the n+ layer 24 is used, the conduction modulation can be promoted more in the n layer 23 in the present invention and hence, the ON voltage can be effectively reduced. In addition, though any optimum condition for the n layer 231 for establishing the withstand voltage is not shown in the semiconductor device 202, the inventors of the present invention find as new knowledge that there is an optimum condition of the n layer 23 for establishing the low ON voltage and the high withstand voltage in IGBT having the conduction modulation as described above.

A prior art similar to this device is shown with the semiconductor device shown in FIG. 9, which has such problems that the semiconductor device has a 6-layered pnpnpn structure, and has difficulty in fabricating the device, the resistance of the p channel layer is large and the turn-off time is long because the holes enters the cathode electrode through the p channel layer formed with the p-type inversion surface of the n layer 231. On the other hand, the semiconductor device 100 of the present invention has such an advantageous aspect that the turn-off operation can be performed promptly because the n layer 23 is depleted when the turn-off operation in which the reversed bias is applied between the p layer 31 and the n layer 23, and the holes stored in the n- layer can be directly transported into the p layer 31.

In the semiconductor device 232 shown in FIG. 10, as the n layer 232 is formed on the whole part below the gate electrode 301 and the p layer 311, and as the sheet carrier density changes in the n layer 232 along the junction interface of the p layer 311, there is such a problem that the sheet carrier density of the part of the n layer 232 located at the side wall of the p layer 311 becomes too high and the withstand voltage decreases if the sheet carrier density of the part of the n layer 232 located below the p layer 311 in order to attempt to increase the storing effect of the holes. In contrast, if the sheet carrier density of the part of the n layer 232 located at the side wall of the p layer 311 is attempted to be optimized in order to establish the sufficient withstand voltage, the sheet carrier density of the part of the n layer 232 located below the bottom face of the p layer 311 decreases and the storing effect of the holes is lost. In addition, in the semiconductor device 232, as the MOS gate faces to the n layer 232 having the high density, the feedback capacitance is so large as to cause the noise. On the other hand, in the semiconductor device of this embodiment, as the sheet carrier density of the n layer 23 is uniformly distributed along the junction interface to the p layer 31, the storing effect of holes can be well established while obtaining enough withstand voltage. As the area of the n layer 23 facing to the bottom of the gate electrode 3 is small, the feedback capacitance decreases less. In this embodiment, by making the thickness of the central part of the gate insulation film 50 larger for forming the gate insulation film 52, the feedback capacitance can be decreased. And furthermore, the inventors found that the storing effect of electrons in the n-layer 22 below the gate can be restricted especially in the semiconductor device having the storing effect of holes in this embodiment, and that the storing effect of holes below the gate can be promoted leading to the lower ON voltage.

The inventors found that it is preferable that the sum of the sheet carrier density of the n layer 23 and the sheet carrier density of the n- layer 22 is made to be $1.5 \times 10^{12}\,\mathrm{cm^{-2}}$ or less in order to establish certainly enough withstand voltage in the semiconductor device. This makes possible to make the n layer 23 depleted when the backward bias is applied and to make the depleted layer widely and deeply enough in the n-layer and reduce the localized concentration of the electric field. According to the studies by the inventors of this invention, this characteristic can be applied to the semiconductor devices of the present invention operated with various rated voltages, and with respect to the withstand voltage Vb(V), it is preferable that the carrier density of the n- layer is $7.5 \times 10^{16}$ /Vb or less, and its thickness is Vb/12 $\mu$m or larger.

As the n layer 23 is added, it is more difficult of the depletion layer to extend than the general IGBT. Therefore, the carriers stay in the n- layer 22 near the n buffer layer 21 and the tail current occurs and the turn-off loss tends to increase. In order to prevent above disadvantages, it is effective that a time-life control with proton and helium is applied locally to the n- layer 22 and the n butter layer 21 near the n butter layer 21. With this control, the tail current does not increase and the high speed switching is enabled. In addition, in the time-life control with proton and helium, the carrier densities of the n-layer 22 and the n butter layer 21 are compensated, and as the region under the life-time control has substantially lower carrier density, the semiconductor device of this embodiment has such an advantageous aspect that the depletion layer easily extends and the high withstand voltage can be established.

Now, a preferable fabrication method for the semiconductor device 100 is described. At first, the n buffer layer 21 and the n- layer 22 are formed with epitaxial on the p+ substrate. The thick gate oxide film 52 is formed on the emitter side surface, and shaped in a designated pattern. Next, the thin gate oxide film 51 is formed on the exposed surface of the n-layer 22. Polycrystal silicon is made to be piled on the thick gate oxide film 52 and the thin gate oxide film 51 as the gate electrode 3. An open hole is formed in the thin gate oxide film 51 and the gate electrode 3 so that adjacent thick gate oxide films 52 may be arranged symmetrically in the horizontal direction. The length of each of the thin gate oxide films 51 at the both sides of the open hole which is identical to each other is so defined as to be longer than the diffusion depth of the n layer 23 in the horizontal direction. Phosphorus ion is implanted from the open hole into the n layer 23 with the mask of the gate electrode 3 and diffused thermally. Next, boron ion is implanted from the open hole into the p layer 31 as its impurity with the mask of the gate electrode 3, and diffused thermally. Next, in order to reduce the resistance of the p layer 31 defined in the horizontal direction below the n+ layer 40, the boron impurities of the p+ layer 32 is implanted into the n+ layer 40 and diffused by using the photoresist so as to reach the underneath of the n+ layer 40. Arsenic ion is implanted into the n+ layer 40 as its impurities by using the photoresist pattern, and diffused thermally. At this time, arsenic is implanted into the gate electrode 3 side of the n+ layer 40 with the mask of the edge of the gate electrode 3 in self alignment. Thus, as all the layers, n layer 23, p layer 31 and n+ layer 4, all reaching the underneath of the thin gate oxide film 51, can be formed in self alignment and with the mask of the edge of the gate electrode 3, the gate threshold voltage can be stabilized. Then, the insulation film 60 is piled up and the open hole is formed by using the photoresist so as to cover the gate electrode 50, and the p+ layer 32 and the n+ layer 40 are made to be short by the emitter electrode 3 in order to contact each other electrically. And furthermore, the collector electrode 1 is also formed in the p+ layer 10 so as to connect each other electrically.

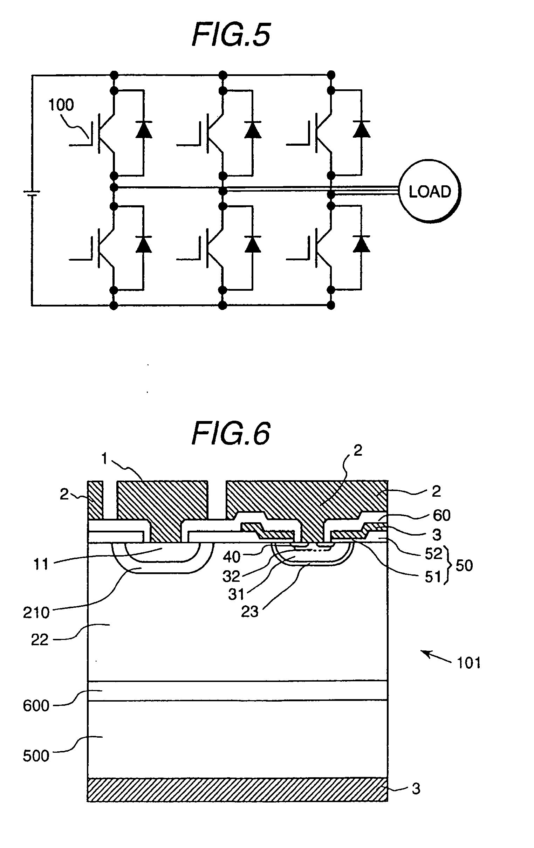

FIG. 5 shows an application example in which the semiconductor device of the present invention is applied to an inverter apparatus used as one of the electric conversion devices. By applying the semiconductor device of the present invention, it will be appreciated that low energy loss and high speed switching which can not be attained in the prior art system can be established without sacrificing a high withstand voltage, and that the gate noise generated through the feedback capacitance can be reduced, and consequently an effective and highly reliable inverter apparatus can be realized.

FIG. 6 is an embodiment in which a semiconductor device not forming part of the claimed invention is applied to a lateral semiconductor device. The emitter electrode 2 and the collector electrode 1 are located on an identical surface, and the supporting part 500 and the supporting electrode 3 are separated and insulated from the n- layer 22 by the insulation layer 600. The semiconductor device shown in FIG. 6 has the same effect as the semiconductor device 100 shown in FIG. 1 in which the electric current passes in the vertical direction. The emitter electrode 2 and the collector electrode 1 formed on an identical surface can be integrated with another devices, and thus, the semiconductor device shown in FIG. 6 can be widely used for IC and LSI.

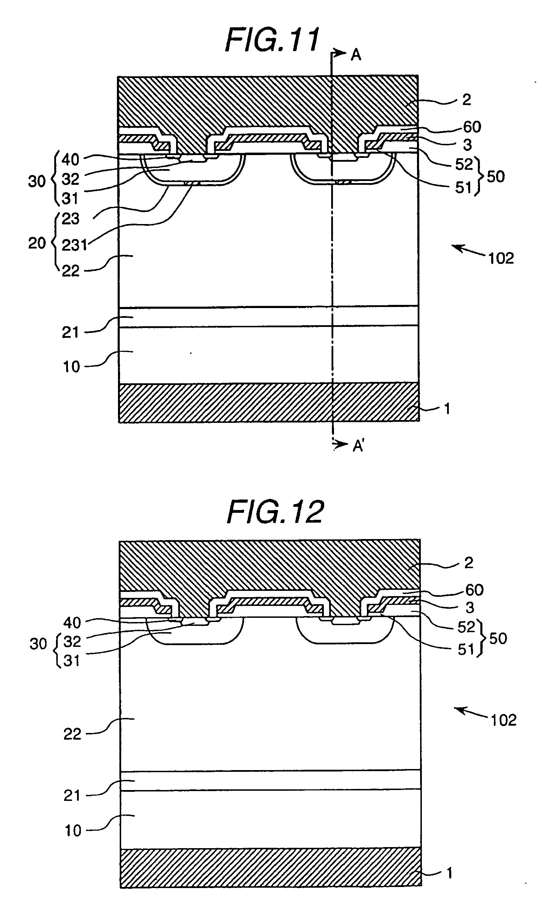

Now, another device not forming part of the claimed invention is described in detail by referring to FIG. 11. The semiconductor device 102 has a pair of main surfaces, the individual surface almost parallel to each other, in which the n butter layer 21 is formed on the p+ layer 10 exposed to one of the main surfaces, and the n- layer 22 is formed on the n buffer layer 21 exposed to the other of the main surfaces. The n layer 23 having the carrier density higher than that of the n- layer 22 is diffused from the other main surface into the n- layer 22. The p layer 31 is so diffused as to be surrounded by the n layer 23. The n+ layer 40 is introduced in the p layer 31. On the surfaces of the p layer 31 and the n layer 23, the gate insulation film 51 is formed on one of the main surfaces so as to bridge the n+ layer 40 and the n- layer 22, and the gate electrode 3 is formed on the gate insulation film 51. On the other main surface, the emitter electrode 2 is formed inn the n+ layer 40 and the p layer 31 and contact with low resistance to the p+ layer 32 extending to the underneath of the n+ layer 40. In the n layer 23, the region 231 having the higher impurity density than another region in the n layer 23 located between adjacent hypothetical perpendiculars extended from the individual internal edges of the adjacent n+ layers in the single p layer 31 is formed partly. This means that the region 31 is located below the contact point with low resistance of the emitter electrode 2. In the region 31, the avalanche breakdown of pn junction causes easily more than another region of the n layer 23. Owing to this property, as described later, the latch-up operation does not occur often in the semiconductor device of the present invention, and the safe operation region is extended.

In case of the semiconductor device having the withstanding voltage 1200V, the carrier density distribution in the cross section at A-A' is similar to FIG. 2. The relation between the thickness of the n layer 23 and its characteristic is similar to FIG. 3.

Though the operation for turning ON the semiconductor device 102 is similar to that shown in FIG. 1, the save operation region can increase in this embodiment because the avalanche occurs in the region 231. This reason is described below. In the conventional IGBT shown in FIG. 12, the electric field concentrates at the peripheral part of the p layer 31 having a large curvature and the avalanche breakdown in the junction arises, and the avalanche current passes the p layer crossing below the n+ layer 40. Then, the voltage drop occurs due to the parasitic resistance below the n+ layer 40, and when the voltage drop gets to be over about 0.7V equivalent to the built-in potential of the pn junction, the thyristor composed of the p layer 10, the n buffer layer, the n- layer 22, n layer 23, the p layer 31 and the n+ layer 40 is turned on. This operation is called "latch up" and determines the upper bound of the safe operation region. By forming the region 231 shown in the embodiment of FIG. 11, the avalanche breakdown occurs inside the n+ layer 40 among the bottom parts of the p layer 31, that is, below the low-resistance contact part of the emitter electrode. Most of the avalanche current does not travel below the p+ layer 40 but passes the p layer 31, and the voltage drop due to the parasitic resistance below the n+ layer 40 decreases and the latch up can be avoided. Consequently, the safe operation region of the semiconductor device 102 shown in FIG.11 can be established to be wide enough and its reliability can be attained to be high enough. In FTG. 1, the region 231 is allowed to be displaced from the middle point between the adjacent gate electrodes 3 as long as its position is located between the adjacent hypothetical perpendiculars extended from the both inner edges of the n+ layer 40 toward the collector electrode 1. In addition, it is allowed to form plural regions 231, and the same effect as described above can be obtained as far as at least one of those regions 231 is located in the above specified region. The region 231 may be formed by specifying the shape of the n layer 23 as described later as well as formed by controlling the impurity density in the region 231 as described in this embodiment. In any case, it is a necessary condition that the withstand voltage of the pn conjunction in the region 231 is lower than the withstand voltage of the pn junction in another region, and that the avalanche break-down occurs easily.

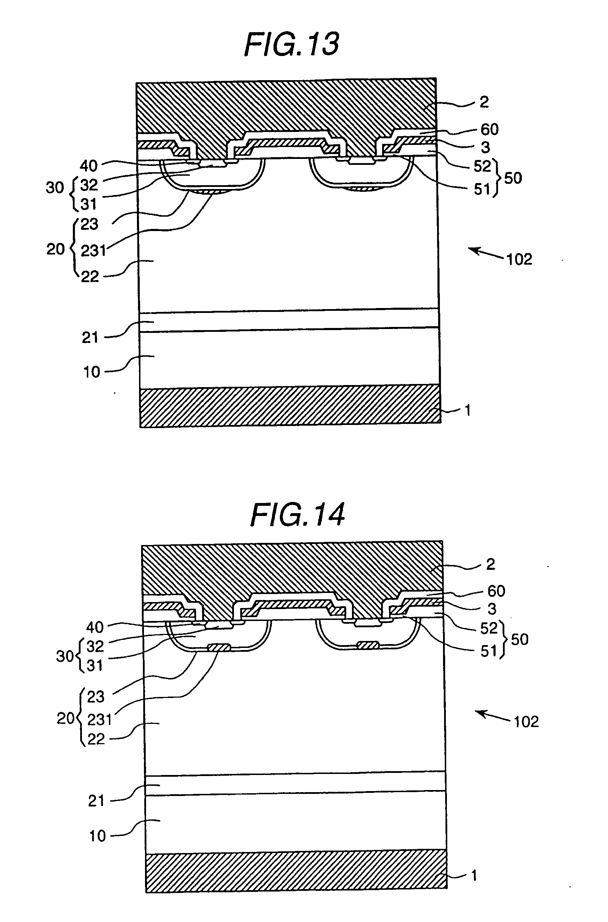

FIG. 13 shows another device not forming part of the claimed invention, and is such an example that the region 231 in which the avalanche break-down occurs easily is fabricated in the following processes. At first, the n buffer layer 21 and the n-layer 22 are formed with epitaxial growth on the p+ substrate 10. The thick gate oxide film 52 is formed on the emitter side surface, and shaped in a designated pattern. Next, the thin gate oxide film 51 is formed on the exposed surface of the n- layer 22. Polycrystal silicon is made to be piled on the thick gate oxide film 52 and the thin gate oxide film 51 as the gate electrode 3. The first open hole is formed in the thin gate oxide film 51 and the gate electrode 3. The length of each of the thin gate oxide films 51 at the both sides of the open hole is so defined as to be identical to each other and to be longer than the diffusion depth of the n layer 23 in the horizontal direction. In order to establish the region 231, at first, the phosphorus ion is implanted through the mask of the second open hole narrower than the first open hole and diffused thermally. Phosphorus ion is implanted from the first open hole into the n layer 23 with the mask of the gate electrode 3 and diffused thermally. At this time, by making the depth of the n layer 231 larger than the depth of the n layer 23, a portion having the n-type concentrated layer is formed in the bottom part of the interface between the n layer 23 and the p layer 31. Next, boron ion is implanted from the first open hole into the p layer 31 as its impurity with the mask of the gate electrode 3, and diffused thermally. Next, in order to reduce the resistance of the p layer 31 defined in the horizontal direction below the n+ layer 40, boron is implanted into the n+ layer 40 so as to reach the deeper region of the n+ layer 40 in order to form the p+ layer 32. arsenic ion is implanted into the n+ layer 40 as its impurities by using the photoresist pattern, and diffused thermally. At this time, arsenic ion is implanted into the gate electrode 3 side of the n+ layer 40 with the mask of the edge of the gate electrode 3 in self alignment. Thus, as all the layers, n layer 23, p layer 31 and n+ layer 40, all reaching the underneath of the thin gate oxide film 51, can be formed in self alignment and with the mask of the edge of the gate electrode 3, the gate threshold voltage can be stabilized. Then, the insulation film 60 is piled up and the open hole is formed by using the photoresist so as to cover the gate electrode 3, and the p+ layer 32 and the n+ layer 40 are made to be short by the emitter electrode 3 in order to contact each other electrically. And furthermore, the collector electrode 1 is also formed in the p+ layer 10 so as to connect each other electrically.

FIG. 14 is another device not forming part of the claimed invention. In the embodiment shown in FIG. 13, the impurities in the region 231 is diffused from the surface of the semiconductor layer. On the other hand, in this embodiment, the n-type impurities are localized near the junction between the p layer 31 and the n layer 23. In order to establish the region 231, after diffusing the n layer 23, ion having high energy is implanted from the open hole of the mask so as to reach the junction between the p layer 31 and the n layer 23, and the n-type region 232 is localized at the bottom part of the n,layer 23. In this embodiment, as the amount of impurities travel below the gate oxide film 51 is small, larger mobility of the channel can be obtained and ON voltage can be reduced.

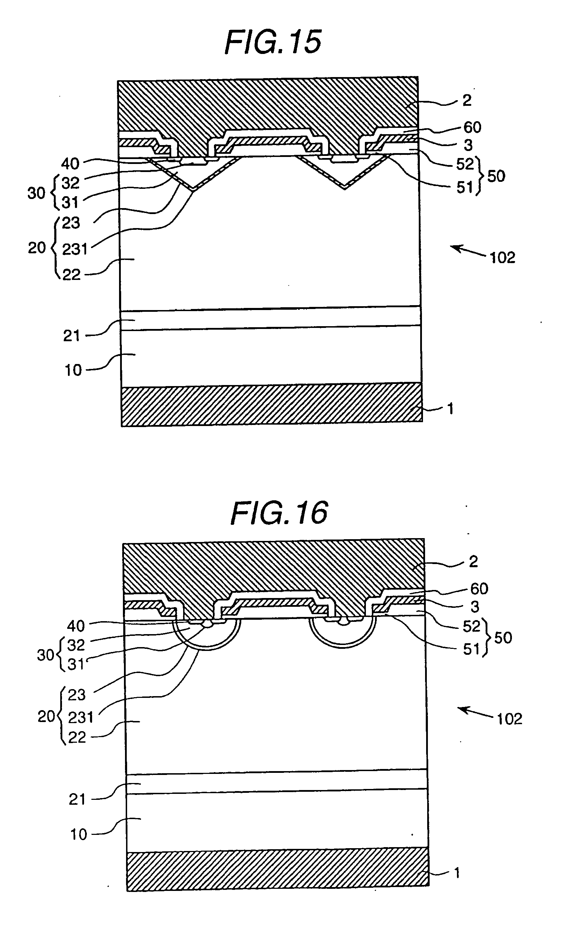

FIG. 15 is another device not forming part of the claimed invention, which is an example for forming a region partially in the n layer 23 in which avalanche break-down occurs easily by controlling the shape of the n layer 23. The n layer 23 is shaped in a straight line at the junction interface in the peripheral part of the p layer, and has a sharp corner at the center bottom of the n layer 23. The curvature of the interface between the bottom part of the p layer 31 and the n layer 23 takes its maximum value at the center bottom of the n layer 23, the electric field is concentrated at the region of the center bottom of the n layer 23, in which the avalanche occurs when voltage applied. Thus, this shape of the n layer 23 gives the same effect as the n-type region shown in FIGS. 11, 13 and 14. With this semiconductor structure, the safe operation region can be extended.

FIG. 16 is another device not forming part of the claimed invention. In FIG. 16, the distance between the adjacent gate electrodes 3 is taken to be small enough to be equivalent to the diffusion depth of the n layer 23, and the center bottom of the n layer 23 is shaped in a curve. As the gate electrode 3 is made of electrical conductive materials and its electric potential is identical anyplace inside, it brings such an electric field buffering effect as a field plate does. With this semiconductor structure, as the intensity of the electric field has its maximum value at the bottom part of the n layer 23 in comparison with the surface of the semiconductor layer, the avalanche occurs at the bottom part of the n layer 23 in the similar manner to the previous embodiment. Consequently, the safe operation region can be extended.

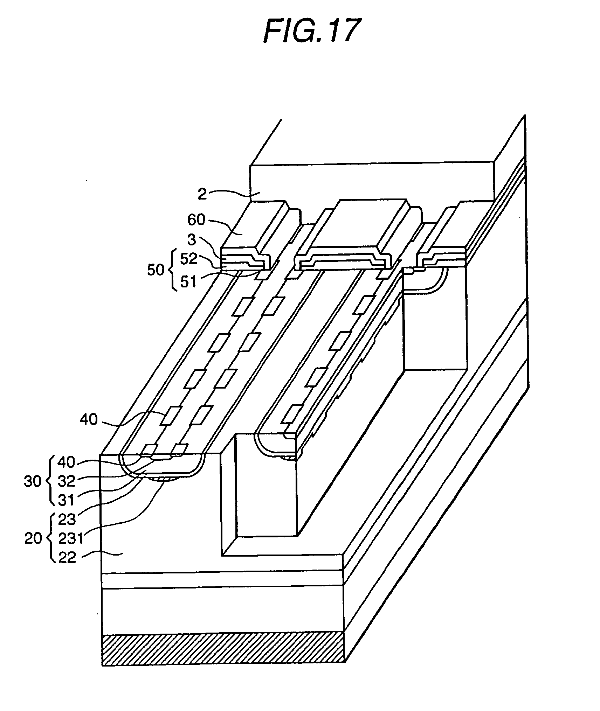

FIG. 17 is an example of applying the semiconductor structure shown in FIG. 13 to the striped cell of IGBT. In FIG. 17, the p layer 31 and the p+ layer 32 are formed in continuous striped regions, and the n+ layers 40 are arranged on the line with a definite interval. In this segmented emitter structure, the emitter layers 40 are arranged periodically with a definite interval, and electrons do not pass through much and the saturation current is so small that the protection for latch-up can be attained effectively. For example, in the device having withstand voltage 1200V, even if its saturation current is made limited by making the width of the n+ layer 40 70% of the whole channel width, ON voltage becomes 85% of ON voltage in the conventional IGBT without an n layer 23. Since the n+ layer 40 and the region 231 are arranged alternately so that the region 231 is not located under the n+ layer 40, the current passing under the n+ layer when the avalanche occurs can be protected certainly. In addition, it is preferable that the region 231 is arranged only under the p layer similarly in the semiconductor device in which the p+ layer 32 and the n+ layer 40 are arranged alternately in a ladder configuration. In this embodiment, the region 231 may be formed with the configurations shown in FIGS. 11, 24, 15 and 16.

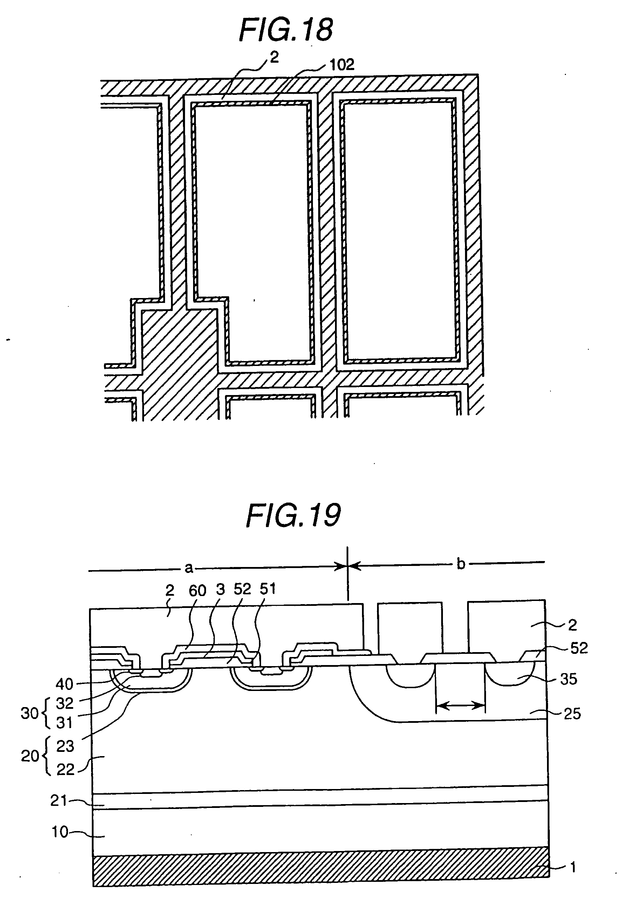

FIG. 18 is an embodiment of applying the present invention to an IGBT chip, which is an example of arranging the striped cells shown in FIG. 17 on the chip. When the semiconductor device is turned on, the electric field is concentrated at such parts as corners and edges on the chip. The semiconductor device 100 shown in FIG. 1 and the semiconductor device 102 shown in FIGS. 11, 3, 14, 15 and 16 are intermingled on the chip. In this arrangement, the semiconductor device 102 is arranged selectively on portions such as corners and edges on the chip on which the electric field is concentrated, and the cell composed of the semiconductor device 100 not including the region 231 is arranged on portions other than corners and edges. Mesh cells are arranged on the ship in the similar manner. In the cell of the semiconductor device without the region 231, by increasing the density of the n layer 23 instead of forming the region 231 having low withstand voltage, the storing effect of holes can be increased while the withstand voltage equivalent to that of the semiconductor device 100 is maintained, and hence, ON voltage decreases further, and consequently, ON voltage for operating the whole chip can be reduced.

FIG. 19 is an embodiment in which a termination region is placed on the outskirts of the active region of the IGBT. The difference from the conventional termination region is that a deep n layer 25 is placed in the termination region. In the semiconductor device 100 shown in FIG. 1, in order to enhance the storing effect of holes, it is effective to make the density of the n layer 23 higher and the density of the n- layer 22 lower in order to make relatively higher the electric potential barrier in relative to the holes in the n- layer. As diffusion phenomena occur from the surface of the n layer 23, if the density of the n- layer 22 is made higher, its surface density also increases, and then, the channel mobility decreases leading to an increase in ON voltage. On the other hand, if the density of the n-layer 22 is made lower, the depletion layer in the n- layer 22 tends to extend, and therefore, it is required to make longer the distance between the adjacent p layers 35 used as field limiting ring in the termination region marked by "b" in FIG. 18. For example, in case that the number of field limiting rings is 6 in a 1200V-class device, when the resistivity of the n- layer is 120 $\Omega$ cm, the interval between the adjacent field limiting rings for is 32 $\mu$m, but when the density is made lower and the resistivity of the n- layer is 200 $\Omega$ cm, it is required to make the interval 40 $\mu$m or longer. The later case causes the increase of the fraction of the termination region in the chip and the increase of the fabrication cost of the devices. By means of forming a deep n layer 25 in the termination region "b", the extension of the depletion layer can be limited and the interval between the field limiting rings 35 can be made shorter. If the density of the n layer 25 is high, the depletion layer can not extend and the electric field concentrates in the device, and then, sufficient withstand voltage can not be established, therefore, it is preferable to make the density of the n layer 25 between $1\times10^{12}$ and $1\times10^{14}$ cm$^{-3}$ .

Similar to the device shown in FIG. 1, the devices shown in FIGS. 11, 13 through 19 can be applied to the electric power conversion apparatus such as inverter apparatus shown in FIG. 5. By applying the semiconductor device of the present invention, it will be appreciated that low energy loss and high speed switching which can not be attained in the prior art system can be established without sacrificing a high withstand voltage, and consequently an effective and highly reliable inverter apparatus can be realized.

According to the present invention, it is enabled to provide a semiconductor device which has such overall features that the device and apparatus can be easily manufactured, the feedback capacitance causing noises is small, high withstand voltage can be easily established, the turn-on voltage is small and the switching operation is fast, and to provide an electric power conversion apparatus using this semiconductor device.

The following clauses not forming part of the claimed invention set out aspects of the disclosure given above:

1. A semiconductor device comprising
a semiconductor substrate having a pair of main surfaces;

a first semiconductor region of first conduction-type located in said substrate;

a second semiconductor region of second conductive-type located on said first semiconductor region;

plural third semiconductor regions of second conductor-type having carrier density higher than carrier density of said second semiconductor region;

a forth semiconductor region of first conductor-type located in said third semiconductor region;

a fifth semiconductor region of second conductor-type located in said forth semiconductor region;

a gate insulation film formed on surfaces of said second, third, forth and fifth semiconductor regions;

a gate electrode formed on said gate insulation films;

an emitter electrode contacting with low resistance to said forth semiconductor region and said fifth semiconductor region; and

a collector electrode contacting with low resistance to said first semiconductor region,

wherein sheet carrier density of said third semiconductor region is $1\times10^{12}$ cm$^{-2}$ or less.

2. A semiconductor device of Clause 1, further comprising a sixth semiconductor region of second conductor-type having carrier density higher than carrier density of said second semiconductor region, inserted between said first semiconductor region and said second semiconductor region.

3. A semiconductor device of Clause 1, wherein the thickness of said third semiconductor region is 4 μm or less.

4. A semiconductor device of Clause 1, wherein a sum of carrier density of said second semiconductor region and carrier density of said third semiconductor device is $1.5\times10^{12}$ cm$^{-2}$ or less.

5. A semiconductor device of Clause 1, wherein a carrier density of said third semiconductor region is $7.5\times10^{16}$ /Vb cm$^{-3}$ or less, and a thickness of said third semiconductor region is V/12 μm or less, in which Vb is withstand voltage of a semiconductor device.

6. A semiconductor device of Clause 1, wherein said gate insulation film is composed of a thin region and a thick region;

there is a region of a thin gate insulation film on a surface of said third semiconductor region and said forth semiconductor region; and

said surface of said second semiconductor region is covered by a gate insulation film having thickness larger than thickness of said thin gate insulation film.

7. A semiconductor device of Clause 2, wherein an impurity for reducing a lifetime of small-numbered carriers is introduced partly in either or both of said second semiconductor region and said sixth semiconductor region; and carrier density of said impurity is lower than carrier density of said second or sixth semiconductor region which generically does not contain said impurity.

8. A semiconductor device of Clause 7, wherein said impurity is proton or helium.

9. A semiconductor device of Clause 1, wherein said first semiconductor region, said second semiconductor region, said third semiconductor region, said forth semiconductor region, said fifth semiconductor region, said emitter region and said collector region are located on an identical surface of said semiconductor substrate.

10. A semiconductor device of Clause 1, wherein said third semiconductor region has a partial region in which avalanche breakdown occurs easily more than another region in said third semiconductor region, said partial region located below a low resistance contact point of said emitter electrode.

11. A semiconductor device of Clause 10, wherein an impurity density in said partial region is larger than an impurity density in said another partial region.

12. A semiconductor device of Clause 10, wherein curvature of a conjunction interface between said third semiconductor region and said forth semiconductor region is largest at said partial region.

13. A semiconductor device of Clause 12, wherein a cross section of said third semiconductor region and said forth semiconductor region shaped in a circle.

14. An electric power conversion apparatus for controlling an electric power to be supplied to a load by a switching device,

wherein a semiconductor device of either of Clauses 1 through 13 is used for said switching device.

**Claims**

1. An insulation gate type bipolar transistor (IGBT) (100) comprising:

a semiconductor substrate having a pair of main surfaces;

a first semiconductor region (10) of a first conductive-type located in the substrate;

a second semiconductor region (22) of a second conductive-type located on the first semiconductor region (10);

plural third semiconductor regions (23) of the second conductive-type having a higher carrier density than the carrier density of the second semiconductor region (22);

a fourth semiconductor region (30) of the first conductive-type located in each third semiconductor region (23);

a fifth semiconductor region (40) of the second conductive-type located in each fourth semiconductor region (30);

a gate insulation film (50) formed on surfaces of the second, third, fourth and fifth semiconductor regions;

a gate electrode (3) formed on the gate insulation film (50) ;

an emitter electrode (2) contacting with low resistance the fourth and fifth semiconductor regions; and

a collector electrode (1) contacting with low resistance the first semiconductor region (10), wherein the sheet carrier density of each third semiconductor region (23) is $1\times10^{12}$ cm$^{-2}$ or less, the volume carrier density of the second semiconductor region (22) is $\dfrac{7.5\times10^{16}}{Vb}$ or

less and the thickness of the second semiconductor region (22) is $\dfrac{Vb}{12}$ $\mu$m or more, where

the withstand voltage of the IGBT (100) is $Vb$ V, and a sum of a sheet carrier density of the second semiconductor region (22) and the sheet carrier density of the third semiconductor regions (23) is $1.5 \times 10^{12}$ cm$^{-2}$ or less, and wherein each third semiconductor region (23) includes a partial region (231) at which avalanche breakdown occurs more easily than another region in the third semiconductor region (23), the partial region (231) being located below a low resistance contact point of the emitter electrode (2), and wherein an impurity density in the partial region is larger than an impurity density in said another region of the third semiconductor region (23), **characterised in that**:

the fourth semiconductor region (30) is formed as a continuous striped region, the fifth semiconductor region (40) is formed as a plurality of emitter layers arranged periodically on the line of the continuous striped region, and the partial region (231) is formed alternately with the emitter layers, so that the partial region (231) is not located under the fifth semiconductor region.

**Patentansprüche**

1. Bipolartransistor mit isoliertem Gate (IGBT)(100) mit:

einem Halbleitersubstrat mit einem Paar von Hauptflächen,
einem in dem Substrat gelegenen ersten Halbleiterbereich (10) eines ersten Leitungstyps,
einem auf dem ersten Halbleiterbereich (10) gelegenen zweiten Halbleiterbereich (22) eines zweiten Leitungstyps,
mehreren dritten Halbleiterbereichen (23) des zweiten Leitungstyps, die eine höhere Ladungsträgerdichte aufweisen als der zweite Halbleiterbereich (22),
einem in jedem dritten Halbleiterbereich (23) gelegenen vierten Halbleiterbereich (30) des ersten Leitungstyps,
einem in jedem vierten Halbleiterbereich (30) gelegenen fünften Halbleiterbereich (40) des zweiten Leitungstyps,
einer auf Oberflächen des zweiten, des dritten, des vierten und des fünften Halbleiterbereichs ausgebildeten Gate-Isolierschicht (50),
einer auf der Gate-Isolierschicht (50) ausgebildeten Gate-Elektrode (3),
einer den vierten und den fünften Halbleiterbereich niederohmig kontaktierenden Emitterelektrode (2) und
einer den ersten Halbleiterbereich (10) niederohmig kontaktierenden Kollektorelektrode (1),
wobei die Flächen-Ladungsträgerdichte jedes dritten Halbleiterbereichs (23) $1\times10^{12}$ cm$^{-2}$ oder weniger, die Volumen-Ladungsträgerdichte des zweiten Halbleiterbereichs (22) $7,5\times10^{16}/V_b$ cm$^{-3}$ oder weniger und die Dicke des zweiten Halbleiterbereichs (22) $V_b/12$ $\mu$m oder mehr beträgt, wobei die Spannungsfestigkeit des IGBT (100) $V_b$ V und die Summe aus der Flächen-Ladungsträgerdichte des zweiten Halbleiterbereichs (22) und der des dritten Halbleiterbereichs (23) $1,5\times10^{12}$ cm$^{-2}$ oder weniger beträgt, wobei jeder dritte Halbleiterbereich (23) einen Teilbereich (231) aufweist, an dem ein Lawinendurchbruch leichter auftritt als an einem anderen Bereich in dem dritten Halbleiterbereich (23), wobei der Teilbereich (231) unter einer niederohmigen Kontaktstelle der Emitterelektrode (2) liegt, und wobei die Störstoffdichte in dem Teilbereich höher ist als in dem anderen Bereich des dritten Halbleiterbereichs (23),
**dadurch gekennzeichnet, dass**
der vierte Halbleiterbereich (30) als kontinuierlicher Streifenbereich ausgebildet ist,
der fünfte Halbleiterbereich (40) in Form mehrerer Emitterschichten vorliegt, die auf der Linie des kontinuierlichen Streifenbereichs periodisch angordnet sind, und

der Teilbereich (231) mit den Emitterschichten alternierend ausgebildet ist, so dass er nicht unter dem fünften Halbleiterbereich liegt.

## Revendications

1.  Transistor bipolaire de type à grille isolée (IGBT) (100) comportant :

    un substrat semi-conducteur ayant une paire de surfaces principales,

    une première région semi-conductrice (10) d'un premier type conducteur localisée dans le substrat,

    une deuxième région semi-conductrice (22) d'un second type conducteur localisée sur la première région conductrice (10),

    plusieurs troisièmes régions semi-conductrices (23) du second type conducteur ayant une densité de porteurs supérieure à la densité de porteurs de la deuxième région semi-conductrice (22),

    une quatrième région semi-conductrice (30) du premier type conducteur localisée dans chaque troisième région semi-conductrice (23),

    une cinquième région semi-conductrice (40) du second type conducteur localisée dans chaque quatrième région semi-conductrice (30),

    un film d'isolation de grille (50) formé sur des surfaces des deuxième, troisième, quatrième et cinquième régions semi-conductrices,

    une électrode de grille (3) formée sur le film d'isolation de grille (50),

    une électrode émettrice (2) en contact avec une faible résistance avec les quatrième et cinquième régions semi-conductrices, et

    une électrode collectrice (1) en contact avec une faible résistance avec la première région semi-conductrice (10),

    dans lequel la densité de porteurs de feuille de chaque troisième région semi-conductrice (23) est de $1\times10^{12}$ cm$^{-2}$ ou inférieure, la densité de porteurs en volume de la deuxième région semi-conductrice (22) est de $\dfrac{7.5\times10^{16}}{Vb}$ cm$^{-3}$ ou moins et l'épaisseur de la deuxième région semi-conductrice (22) est de $\frac{Vb}{12}$ μm ou plus, où la tension de tenue du transistor IGBT (100) est Vb V, et une somme d'une densité de porteurs de feuille de la deuxième région semi-conductrice (22) et de la densité de porteurs de feuille des troisièmes régions semi-conductrices (23) est de 1,5 x $10^{12}$ cm$^{-2}$ ou inférieure, et

dans lequel chaque troisième région semi-conductrice (23) inclut une région partielle (231) au niveau de laquelle un claquage par avalanche survient plus facilement que dans une autre région dans la troisième région semi-conductrice (23), la région partielle (231) étant localisée au dessous d'un point de contact à faible résistance de l'électrode émettrice (2), et

dans lequel une densité d'impuretés dans la région partielle est supérieure à une densité d'impuretés dans ladite autre région de la troisième région semi-conductrice (23),

**caractérisé en ce que** :

    la quatrième région semi-conductrice (30) est formée en tant que région à bande continue,

    la cinquième région semi-conductrice (40) est formée en tant qu'une pluralité de couches émettrices agencées périodiquement sur la ligne de la région à bande continue, et la région partielle (231) est formée alternativement avec les couches émettrices, de sorte que la région partielle (231) n'est pas localisée sous la cinquième région semi-conductrice.

*FIG.1*

*FIG.2*

WITHSTAND VOLTAGE:1200V

## FIG.3

## FIG.4

## FIG.5

## FIG.6

## FIG.7

## FIG.8

## FIG.9

## FIG.10

## FIG.11

## FIG.12

FIG.13

FIG.14

## FIG.15

## FIG.16

# FIG.17

## FIG.18

## FIG.19

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 61150378 A
- JP 1986 A
- JP 5082775 A
- JP 63157477A A

- EP 0735591 A
- JP 3205832 A
- GB 2113907 A

**Non-patent literature cited in the description**

- *International Symposium of Power Semiconductor Devices and ICs,* 1996, 349-352